# EUROPÄISCHE PATENTSCHRIFT

(11) **EP 2 700 162 B1**
(45) Veröffentlichungstag und Bekanntmachung des Hinweises auf die Patenterteilung: **16.03.2016**
(21) Anmeldenummer: 12718132.9
(22) Anmeldetag: 18.04.2012
(51) Int. Cl.: H03H 1/00, H03H 7/01

(54) **AUSLÖSCHUNG PARASITÄRER INDUKTIVITÄTEN IN ZU ELEKTRISCHEN WANDLERN PARALLEL GESCHALTETEN FILTERKONDENSATOREN IN EINEM BORDNETZ FÜR EIN FAHRZEUG**
CANCELLATION OF PARASITIC INDUCTANCE IN FILTER CAPACITORS CONNECTED IN PARALLEL TO ELECTRIC CONVERTERS IN AN ELECTRICAL SYSTEM OF A VEHICLE
ÉLIMINATION D'INDUCTANCES PARASITES DANS DES CONDENSATEURS DE FILTRAGE MONTÉS EN PARALLÈLE AVEC DES CONVERTISSEURS ÉLECTRIQUES, DANS UN RÉSEAU DE BORD D'UN VÉHICULE

(30) Priorität: 21.04.2011 DE 102011007833
(43) Veröffentlichungstag der Anmeldung: 26.02.2014
(73) Patentinhaber: Robert Bosch GmbH, 70442 Stuttgart (DE)
(72) Erfinder: BENECKE, Jens, 77815 Buehl (DE)
(86) Internationale Anmeldenummer: PCT/EP2012/057060
(87) Internationale Veröffentlichungsnummer: WO 2012/143384

(56) Entgegenhaltungen:
- EP-A1- 1 783 900
- WO-A1-03/073608
- JP-A- 10 200 357
- US-A1- 2007 241 838

## Beschreibung

### Technisches Gebiet

Die vorliegende Erfindung betrifft Filterschaltungen zum Reduzieren elektrischer Störemissionen.

### Stand der Technik

Störemissionen werden in Schaltungen hervorgerufen, wenn hochfrequente Ströme fließen, die durch den Betrieb eines elektrischen Geräts entstehen. Die Leiterbahnen des elektrischen Gerätes können diese unbeabsichtigten hochfrequenten Ströme nicht nur an andere angeschlossene elektrische oder elektronische Geräte direkt ausgeben und so Funktionsstörungen hervorrufen, durch Ihre induktiven und kapazitiven Eigenschaften wirken die Leiterbahnen auch wie Antennen, die diese unbeabsichtigten hochfrequenten Ströme in Form von elektromagnetischen Wellen an die Umgebung abgegeben, die ihrerseits in elektronischen und elektrischen Geräten in der Umgebung Störungen hervorrufen. Derartige elektromagnetische Wellen sind auch als Funkstörstrahlung bekannt.

In einem elektrischen Wandler entstehen derartige Störemissionen beispielsweise bei schnellen Strom- und Spannungsänderungen, wie sie beim Ein- und Ausschalten des elektrischen Wandlers auftreten.

Zur Vermeidung der Störemissionen und der Funkstörstrahlung wird in herkömmlichen elektrischen Wandlern versucht, die Ausbreitung dieser Störemissionen durch Kurzschluss der Störemissionen am Ausgang des elektrischen Wandlers mit einer Kapazität oder durch Dämpfung der Störemissionen mit einer Induktivität zu vermeiden. Aufgrund parasitärer Effekte in den entsprechenden Spulen und Kondensatoren ist die Wirkung dieses Ansatzes jedoch begrenzt.

Es ist Aufgabe, eine Filterschaltung mit verbesserter Unterdrückung von hochfrequenten Störungen zur Verfügung zu stellen.

### Offenbarung der Erfindung

Diese Aufgabe wird durch die Schaltung nach Anspruch 1 sowie durch die Anordnung und das Verfahren nach den nebengeordneten Ansprüchen gelöst.

Weitere vorteilhafte Ausgestaltungen sind den abhängigen Ansprüchen angegeben.

Gemäß einem ersten Aspekt der Erfindung ist eine Filterschaltung zum Reduzieren elektrischer Störemissionen in einem Bordnetz eines Kraftfahrzeugs vorgesehen, umfassend:
- eine erste Induktivität im einem Serienzweig; und
- eine Kapazität in einem Parallelzweig, wobei die erste Induktivität und die Kapazität über einen Knoten miteinander verbunden sind; und
- eine zweite Induktivität im Reihenzweig, die mit der ersten Induktivität und der Kapazität über den Knoten verbunden ist, wobei die erste Induktivität mit der zweiten Induktivität magnetisch gekoppelt ist, so dass eine parasitäre Induktivität im Parallelzweig reduziert wird.

Die erfindungsgemäße Filterschaltung hat den Vorteil, dass sie einerseits Störemissionen aus der elektrischen Energiequelle oder der elektrischen Last wirkungsvoll auslöscht und so Funkstörstrahlung vermeidet und andererseits den Einsatz kostengünstiger Filterkondensatoren zum Kurzschließen der Störemissionen ermöglicht. Dieser Vorteil wird dadurch erreicht, dass parasitäre Leitungseigenschaften zwischen der Induktivität und der Kapazität durch die Kopplung der beiden Induktivitäten ausgelöscht werden. Dadurch dämpfen einerseits die beiden Induktivitäten durch ihre Hochohmigkeit für hochfrequente Ströme die Störemissionen, andererseits schließt die Kapazität durch ihre Parallelschaltung zum elektrischen Wandler die Störemissionen kurz. Parasitäre Induktivitäten zwischen den beiden Induktivitäten und der Kapazität werden durch eine virtuelle negative Induktivität ausgelöscht, die als Ersatzelement für die magnetische Kopplung der Induktivitäten dient. Die Wirkung der Kapazität bleibt daher über einen größeren Frequenzbereich erhalten. Überraschender Weise können für die kurzschließende Kapazität und die Verbindungsleitungen kostengünstige Bauelemente gewählt werden, da es die Erfindung erlaubt, ihre parasitären Eigenschaften bei der Auswahl der Bauelemente unberücksichtigt zu lassen. Dadurch dämpft die erfindungsgemäße Filterschaltung hochfrequente Stromanteile nicht nur besser als vergleichbare Schaltungen nach dem Stand der Technik, es ist darüber hinaus auch noch kostengünstig realisierbar.

In einer bevorzugten Weiterbildung der Erfindung können die erste und zweite Induktivität als Wicklungen ausgebildet sein, so dass sehr hohe Induktivitäten erzielbar sind.

In einer weiteren bevorzugten Ausbildung der Erfindung können die Wicklungen der ersten und zweiten Induktivität als eine einzige Spule ausgebildet sein, so dass der Knoten auf der Wicklung der einzigen Spule angeordnet ist. Auf diese Weise können als Induktivitäten in der Filterschaltung Entstördrosseln aus der elektrischen Energiequelle, der elektrischen Last oder an anderer Stelle des Bordnetzes hineingezogen werden, die bereits zur Dämpfung von Störemissionen vorgesehen sind. Für beide Induktivitäten des erfindungsgemäßen Filters können so bereits vorhandene Bauelemente verwendet werden, was zu einer weiteren Kostenersparnis führt. Darüber hinaus reicht ein einziges Bauelement für die beiden Induktivitäten aus, wodurch für den Filter verbesserte Packungsdichte erreicht werden kann.

In einer anderen Ausführung der Erfindung kann die Kopplung zwischen den beiden Induktivitäten derart gewählt sein, dass eine die Kopplung repräsentierende negative Induktivität, die im Ersatzschaltbild der Induktivitäten in Reihe zur Kapazität geschaltet ist, die parasitäre Induktivität auslöscht. Somit lässt sich durch eine geeignete Dimensionierung der beiden Induktivitäten und deren magnetischer Kopplung die parasitäre Induktivität, die die Dämpfungswirkung hochfrequenter Stromanteile des Bordnetzes mindert, vollständig auslöschen.

In einer weiteren bevorzugten Ausführung der Erfindung kann die Kapazität an den Knoten in der Spule durch eine Lötverbindung elektrisch angeschlossen sein, so dass die erfindungsgemäße Filterschaltung auf einfache Weise in Serie herstellbar ist.

In einer Weiterbildung der Erfindung kann die Lötverbindung die beiden Induktivitäten und die Kapazität miteinander elektrisch verbinden Auf diese Weise wirkt die Lötverbindung wie eine Temperaturschmelzsicherung, die im Falle eines zu hohen Stromes durch die Induktivitäten und einer damit verbundenen thermischen Erwärmung des die Induktivitäten erzeugenden elektrischen Bauelemente, wie der Spule, den Strom unterbricht und somit auch zur Sicherheit der elektrischen Energiequelle, der elektrischen Last und der erfindungsgemäßen Filterschaltung beiträgt.

Gemäß einem weiteren Aspekt der Erfindung weist ein elektrischer Wandler zum Wandeln zwischen mechanischer und elektrischer Energie einen elektrischen Anschluss auf, an den eine erfindungsgemäße Filterschaltung nach einem der vorstehenden Ansprüche angeschlossen ist. Aufgrund der vorhandenen parasitären Induktivität in herkömmlichen Schaltungen zur Reduktion elektrischer Störemissionen war die Bandbreite, in denen diese herkömmlichen Schaltungen ihrer reduzierende Wirkung entfalten konnten auf 30 MHz begrenzt. Durch den Einsatz der erfindungsgemäßen Filterschaltung können nun hochfrequente Stromanteile selbst von 200 MHz noch wirkungsvoll gefiltert und so reduziert werden. Bei exakter Parametrisierung der magnetischen Kopplung auf die parasitäre Induktivität der Kapazität kann diese obere Grenzfrequenz theoretisch beliebig weit erhöht werden.

In einer Weiterbildung der Erfindung ist eine Anordnung mit einem elektrischen Wandler, mit einem Bordnetz zum Übertragen von elektrischer Energie von oder zu dem Wandler und mit der obigen Filterschaltung vorgesehen.

In einer bevorzugten Weiterbildung der Erfindung ist der Elektromotor ein Startermotor zum Start eines Verbrennungsmotors. Derartige Verbrennungsmotoren werden vielfach in Kraftfahrzeugen eingesetzt, die heutzutage einen komplexen elektronischen Aufbau haben. Durch hohe Sicherheitsstandards im Straßenverkehr muss für wenigstens einen Teil der im Kraftfahrzeug verwendeten elektronischen Komponenten eine hohe Ausfallsicherheit garantiert sein, so dass diese elektronischen Komponenten robust gegen die vom Startermotor abgegebenen Störemissionen sein müssen. Elektronische Komponenten in einem Kraftfahrzeug, die an ein herkömmliches Bordnetz angeschlossen sind, erfüllen zwar die Anforderungen an die Robustheit gegen Störemissionen, die erfindungsgemäße Anordnung erlaubt es jedoch durch die Reduktion von Störemissionen die Robustheit dieser elektronischen Bauelemente gegen Störemissionen herabzusetzen, so dass sie entweder auf andere Funktionen optimiert werden können oder das für vergleichbare Funktionen kostengünstigere Bauelemente auswählbar sind.

Gemäß einem weiteren Aspekt der Erfindung weist ein Verfahren zum Reduzieren elektrischer Störemissionen eines elektrischen Wandlers die folgenden Schritte auf: Filtern des elektrischen Stromes aus oder zu dem elektrischen Wandler mit einer ersten Induktivität und Weiterleiten des gefilterten elektrischen Stromes an eine zweite mit der ersten Induktivität magnetisch gekoppelten Induktivität und an eine Kapazität, so dass eine parasitäre Induktivität zwischen der Kapazität und dem Knoten reduziert wird.

### Kurzbeschreibung der Zeichnungen

Bevorzugte Ausführungsformen der vorliegenden Erfindung werden nachfolgend anhand der beigefügten Zeichnungen näher erläutert. Es zeigen:
Figur 1 ein Schaltbild einer Filterschaltung zwischen einem Generator und einer Last gemäß dem Stand der Technik;
Figur 2 ein Schaltbild einer Filterschaltung zwischen einem Generator und einer Last gemäß einem Ausführungsbeispiel der Erfindung;
Figur 3 ein Ersatzschaltbild der Schaltung der Figur 2;
Figur 4 ein Diagramm, in dem die Dämpfung der Filterschaltung aus den Figuren 1 bis 3 über die Frequenz aufgetragen ist; und
Figur 5 eine schematische Darstellung eines Aufbaus der Filterschaltung aus den Figuren 2 und 3.

### Ausführungsformen der Erfindung

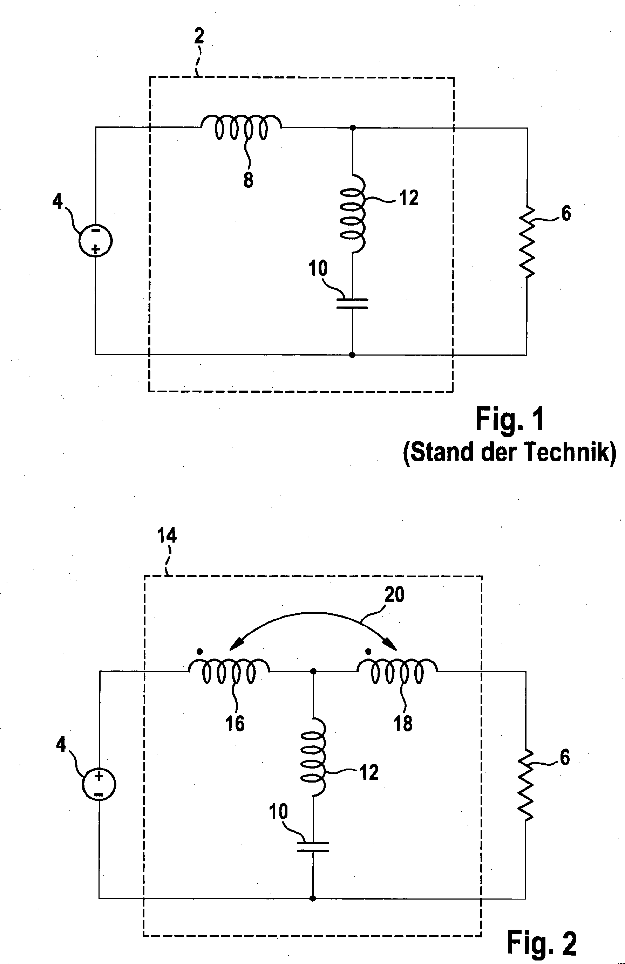

Es wird auf Figur 1 Bezug genommen. Darin ist eine Filterschaltung 2 zwischen einer elektrischen Energiequelle 4 und einer elektrischen Last 6 gezeigt. Die erfindungsgemäße Filterschaltung 2 ist Teil eines Bordnetzes, das in einem Fahrzeug die elektrische Energiequelle 4 und die elektrische Last 6 miteinander verbindet.

Die elektrische Energiequelle 4 kann ein elektrischer Wandler zur Abgabe von elektrischer Energie sein, der mechanische Energie in elektrische Energie umwandelt. Ein solcher elektrischer Wandler ist beispielsweise ein Generator, der eine mechanische Bewegungsenergie aufnimmt und sie mittels elektrischer Induktion in elektrische Energie an die Filterschaltung 2 abgibt. Andere Arten derartiger elektrischer Wandler können Batterien sein, die chemische Energie in elektrische Energie umwandeln oder Transformatoren, die elektrische Energie in elektrische Energie wandeln.

In gleicher Weise kann auch die Last 6 ein elektrischer Wandler zur Aufnahme von elektrischer Energie sein, der elektrische Energie von der Filterschaltung 2 aufnimmt und in mechanische Energie umsetzt. Ein derartiger elektrischer Wandler ist beispielsweise ein Motor, der elektrische Energie über ein Magnetfeld in ein mechanisches Drehmoment umsetzt. Derartige Elektromotoren werten beispielsweise bei Kraftfahrzeugen als Startermotoren zum Start eines Verbrennungsmotors eingesetzt. Weitere Beispiele für elektrische Wandler zur Aufnahme elektrischer Energie sind Akkumulatoren im Ladezustand, die elektrische Energie in chemische Energie umsetzen oder Transformatoren.

Sowohl die elektrische Energiequelle 4 als auch die Last 6 können Störemissionen erzeugen. Das können beispielsweise hochfrequente Schalttransiente sein, die beim Zu- bzw. Abschalten der elektrischen Energiequelle 4 und/oder der Last 6 zu bzw. von der in Figur 1 gezeigten Schaltung entstehen können. Derartige hochfrequente Schalttransiente können nicht nur innerhalb der in Figur 1 gezeigten Schaltung zur Funktionsstörung einzelner Bauelemente führen, da die Leiterbahnen wie eine Antenne wirken, werden diese hochfrequenten Schalttransiente auch als Funkstörstrahlung an die Umgebung abgegeben und können andere elektronische Geräte in ihrer Funktion beeinträchtigen. Um dies zu vermeiden, ist die Filterschaltung 2 vorgesehen, um derartige Störemissionen zu filtern.

Eine herkömmliche Filterschaltung 2, wie sie in Figur 1 gezeigt ist, weist eine Entstördrossel 8 und einen Entstörkondensator 10 auf. Für Störemissionen, die beispielsweise aus der elektrischen Energiequelle 4 abgegebenen werden, wirkt die Entstördrossel 8 hochohmig und dämpft so die Störemissionen. Der Entstörkondensator 10 ist sowohl zur elektrischen Energiequelle 4 parallel geschaltet, so dass Störemissionen aus der elektrischen Energiequelle 4 durch den Entstörkondensator 10 kurz geschlossen sind. Die Wirkung des Entstörkondensators 10 ist jedoch durch parasitäre Induktivitäten 12, wie beispielsweise Leitungsinduktivitäten auf dem Weg zum Entstörkondensator 10 und Kontaktinduktivitäten zwischen den Leiterbahnen der Filterschaltung 2 und dem Entstörkondensator 10, begrenzt. Das heißt, dass die parasitären Induktivitäten 12 und der Entstörkondensator 10 zusammen einen Reihenschwingkreis mit einer Resonanzfrequenz bilden. Nahe der Resonanzfrequenz ist die Dämpfung der Störemissionen wirkungsvoll. Störemissionen mit stark von der Resonanzfrequenz abweichenden Frequenzen werden jedoch weniger wirkungsvoll gedämpft.

Eine Möglichkeit zur Wirkungssteigerung wäre, den Entstörkondensator 10 aus der Filterschaltung 2 zu entfernen. Da die Störemissionen jedoch teils sehr hohe Stromamplituden aufweisen, könnte die Entstördrossel 8 dadurch stark erhitzt und beschädigt werden.

Es wird auf Figur 2 Bezug genommen. In Figur 2 werden zu Figur 1 gleiche Elemente mit gleichen Bezugszeichen versehen und nicht noch einmal erläutert.

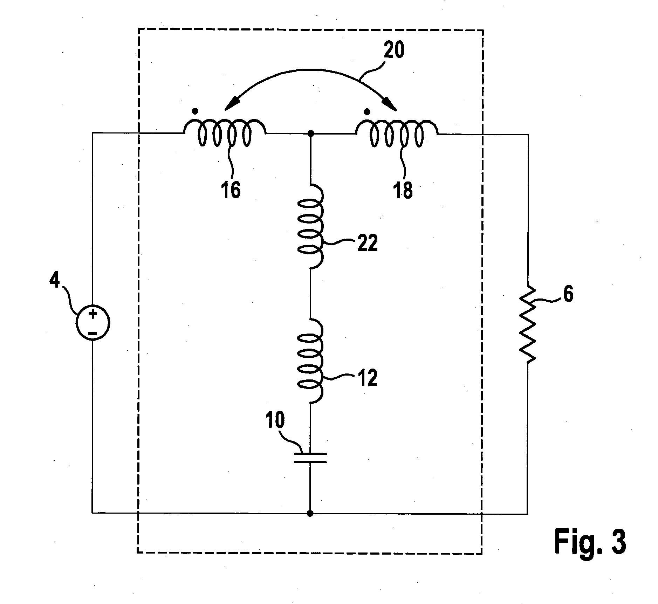

In Figur 2 ist eine Filterschaltung 14 zwischen einer elektrischen Energiequelle 4 und einer Last 6 gemäß der Erfindung gezeigt. Die in Figur 1 gezeigte Entstördrossel 8 ist in Figur 2 durch zwei gekoppelte Induktivitäten 16 und 18 ersetzt, die mit einem Kopplungsfaktor 20 von größer Null miteinander verkoppelt sind. Figur 3 zeigt ein Ersatzschaltbild dieser Filterschaltung 14, in der der Kopplungsfaktor 20 Null und durch eine negative Induktivität 22 ersetzt ist. Die negative Induktivität 22 liegt in Reihe zum Entstörkondensator 10 und zur parasitären Induktivität 12 und kann so wenigstens teilweise die parasitäre Induktivität 12 auslöschen. Durch eine geeignete Dimensionierung der gekoppelten Induktivitäten 16 und 18 kann die parasitäre Induktivität 12 komplett ausgelöscht werden, worauf an späterer Stelle näher eingegangen wird. Aber auch bei nicht exakter Dimensionierung dieser beiden Induktivitäten 16 und 18 ist das erfindungsgemäße Prinzip zur Auslöschung der parasitären Induktivität 12 wirksam.

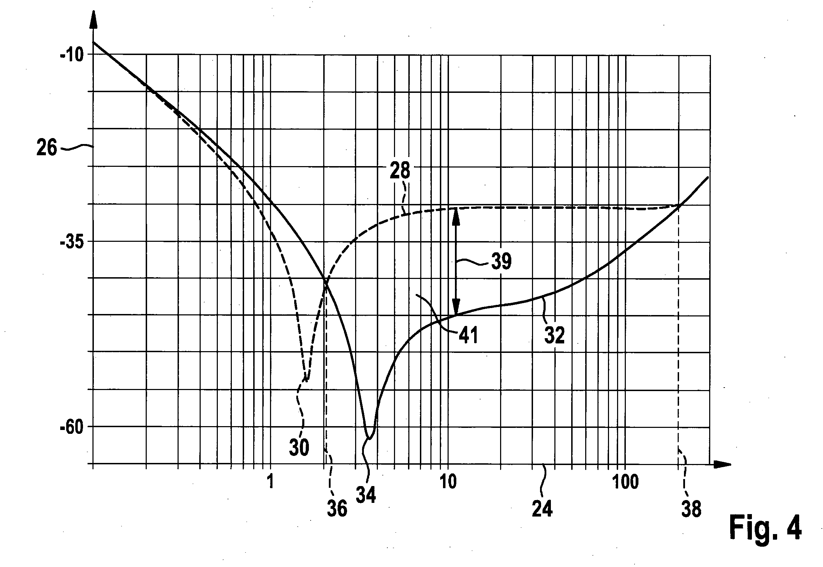

Figur 4 zeigt ein Diagramm, in dem die Störemissionsdämpfung durch eine Filterschaltung 2 gemäß dem Stand der Technik und durch eine erfindungsgemäße Filterschaltung 14 aufgetragen ist.

Für die Erstellung des Diagramms in Figur 4 wurde für die Last 6 ein Widerstand von 50Ω gewählt. Der Entstörkondensator weist 1µF auf. Die Entstördrossel 8 im Stand der Technik weist 4,01µH auf. Die erste gekoppelte Induktivität 16 in der erfindungsgemäßen Filterschaltung 14 weist 4µH und die zweite gekoppelte Induktivität 18 weist 10nH auf. In der Summe entsprechen die erste und zweite Induktivität 16, 18 der erfindungsgemäßen Filterschaltung 14 der Induktivität 8 der herkömmlichen Filterschaltung 2. In Figur 4 ist auf der X-Achse logarithmisch die Frequenz 24 der Störemissionen in MHz und auf der y-Achse die Störemissionsdämpfung 26 in Dezibel aufgetragen. Eine erste Kurve 28 in dem Diagramm der Figur 4, die in gestrichelter Linie gezeichnet ist, zeigt das Dämpfungsverhalten der herkömmlichen Filterschaltung 2 aus Figur 1. Die Resonanzfrequenz 30 der herkömmlichen Filterschaltung 2 mit den oben angegebenen Werten liegt bei ca. 1,5 MHz. Eine zweiten Kurve 32 in dem Diagramm der Figur 4, die mit einer durchgezogenen Linie dargestellt ist, zeigt das Dämpfungsverhalten der Filterschaltung 14 gemäß der Erfindung aus den Figuren 2 und 3. Die Resonanzfrequenz 34 der erfindungsgemäßen Filterschaltung 14 mit den oben angegebenen Werten liegt bei ca. 3,5 MHz.

Wie in Figur 4 gezeigt, ermöglicht die erfindungsgemäße Filterschaltung 14 gegenüber der herkömmlichen Filterschaltung 2 eine Senkung der Störemissionen in einem Bereich zwischen einer unteren Grenzfrequenz 36 von ca. 2 MHz und einer oberen Grenzfrequenz 38 von ca. 200 MHz. Der Betrag 39 dieser Senkung der Störemissionen beträgt durchschnittlich etwa 15 dB.

Durch eine geeignete Dimensionierung der beiden Induktivitäten 16, 18 kann dieser durchschnittliche Betrag 39 der Senkung der Störemissionen solange gesteigert werden, bis die negative Induktivität 22 die parasitäre Induktivität 12 vollständig ausgelöscht. In Figur 4 ist dieser Idealzustand nicht gezeigt. Als Kriterium für das Erreichen dieses Idealzustandes könnte beispielsweise die Fläche 41, die von den beiden Kurven 28, 32 zwischen den beiden Grenzfrequenzen 36, 38 begrenzt wird, maximiert werden.

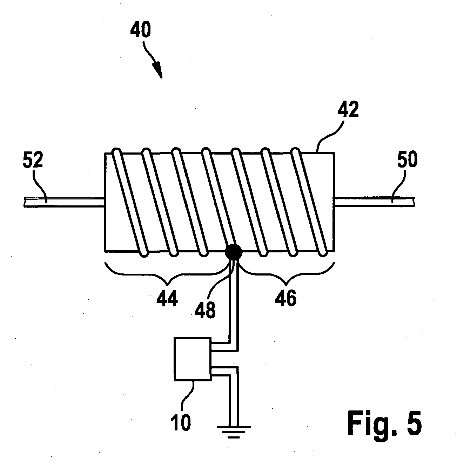

Es wird auf Figur 5 Bezug genommen. Darin ist ein Aufbau 40 für die erfindungsgemäße Filterschaltung 14 aus den Figuren 2 und 3 gezeigt. Eine Spule 42 ist darin in einen ersten Teilbereich 44 und einen zweiten Teilbereich 46 unterteilt. Beide Teilbereiche 44, 46 sind zusammen mit dem Entstörkondensator 10 aus den Figuren 1 bis 3 über eine Lötstelle 48 miteinander elektrisch verbunden. Die beiden elektrischen Anschlüsse 50 und 52 der Filterschaltung 40 können dann entsprechend mit der Last 6 und der elektrischen Energiequelle 4 aus den Figuren 1-3 verbunden werden.

Die Spule 42 kann eine herkömmliche Entstördrossel sein, wie sie beispielsweise bereits in Startermotoren für Verbrennungsmotoren zur Reduktion von Störemissionen verwendet wird. Über die Lötstelle 48 lässt sich eine derartige Entstördrossel in zwei miteinander magnetisch gekoppelte Induktivitäten aufteilen. Für das obige Rechenbeispiel müssten dann (unter der Vernachlässigung von Randeffekten) die Wicklungen der herkömmlichen Entstördrossel im Verhältnis von 20:1 aufgeteilt werden, vorausgesetzt, die einzelnen Spulenwindungen sind mit gleicher Steigung und gleichem Abstand gewickelt. Je nach Anforderung kann das erf.gem. Prinzip mit mehreren oder einer einzigen Induktivität realisiert werden, was zu einer höheren Packungsdichte der erfindungsgemäßen Filterschaltung 14 führt. Schließlich wirkt die Lötstelle 48 auch als Temperaturschmelzsicherung, die im Falle eines Überstromes durch die Spule 42 den Strom unterbricht, und so die Spule 42 vor Überhitzung schützt.

Anstatt einer Aufteilung von 20:1 wäre auch eine Kürzung des Drosselkerns oder eine Verschiebung der Wicklungen über den Kern möglich, so dass eine oder mehrere Windungen nicht mehr um den Kern gewickelt werden und so zur Parametrisierung der gewünschten virtuellen negativen Induktivität gezielt die magnetische Kopplung zwischen dieser Windung und den restlichen Windungen einstellen. Diese letzte(n) Windung(en) könnte(n) auch, um die magnetische Kopplung weiter zu verkleinern, mit einem größeren Abstand zu den restlichen Windungen gewickelt werden.

Auch eine Anpassung der Drosselkernform oder -dimensionen, der Windungsform oder -zahl, der Windungsabstände oder anderer Parameter der Drossel können zum Einstellen dieser magnetischen Kopplung variiert werden.

Die vorliegende Erfindung schlägt vor, in einer Filterschaltung zum Reduzieren elektrischer Störemissionen eines elektrischen Wandler eine parasitäre Induktivität auf dem Weg zu einem Entstörkondensator, der zum elektrischen Wandler parallel geschaltet ist, mit einer durch zwei miteinander magnetisch gekoppelten Induktivitäten erzeugten negativen Induktivität auszulöschen.

## Patentansprüche

1. Filterschaltung zum Reduzieren elektrischer Störemissionen in einem Bordnetz (2) eines Kraftfahrzeugs, umfassend:
- eine erste Induktivität (16) im einem Serienzweig; und
- eine Kapazität (10) in einem Parallelzweig, wobei die erste Induktivität (16) und die Kapazität (10) über einen Knoten miteinander verbunden sind;
- eine zweite Induktivität (18) im Reihenzweig, die mit der ersten Induktivität (16) und der Kapazität (10) über den Knoten verbunden ist, wobei die erste Induktivität (16) mit der zweiten Induktivität (18) magnetisch gekoppelt ist, so dass eine parasitäre Induktivität (12) im Parallelzweig reduziert wird,
- die erste und zweite Induktivität (16, 18) als eine einzige Spule (42) ausgebildet sind, so dass der Knoten auf einer Wicklung der einzigen Spule angeordnet ist,
**dadurch gekennzeichnet,**
- **dass** die beiden Induktivitäten (16, 18) und die Kapazität (10) durch eine Lötverbindung (48) miteinander elektrisch verbunden sind, wobei die Lötverbindung (48) als eine Temperaturschmelzsicherung dient, die im Falle eines Überstromes durch die Spule (42) den Strom unterbricht, und so die Spulen (42) vor Überhitzung schützt.

2. Filterschaltung nach Anspruch 1, wobei die erste und zweite Induktivität (16, 18) als Wicklungen ausgebildet sind.

3. Filterschaltung nach einem der vorstehenden Ansprüche, wobei die Kopplung (20) zwischen den beiden Induktivitäten (16, 18) derart gewählt ist, dass eine die Kopplung (20) repräsentierende negative Induktivität (22), die im Ersatzschaltbild der Induktivitäten (16, 18) in Reihe zur Kapazität (10) geschaltet ist, die Wirkung der parasitären Induktivität kompensiert und sie damit (12) auslöscht.

4. Anordnung mit einem elektrischen Wandler, mit einem Bordnetz zum Übertragen von elektrischer Energie von oder zu dem Wandler und mit einer Filterschaltung nach einem der vorstehenden Ansprüche.

5. Anordnung nach Anspruch 6, wobei der elektrische Wandler ein Elektromotor ist.

6. Anordnung nach Anspruch 7, wobei der Elektromotor ein Startermotor zum Start eines Verbrennungsmotors ist.

7. Verfahren zum Reduzieren elektrischer Störemissionen in einem Bordnetz (2) eines Kraftfahrzeugs mit den Schritten:
- Bereitstellen einer Filterschaltung mit einer ersten Induktivität (16) im einem Serienzweig und einer Kapazität (10) in einem Parallelzweig, wobei die erste Induktivität (16) und die Kapazität (10) über einen Knoten miteinander verbunden sind;
- Vorsehen einer zweiten Induktivität (18) im Reihenzweig, die mit der ersten Induktivität (16) und der Kapazität (10) über den Knoten verbunden wird, wobei die erste Induktivität (16) mit der zweiten Induktivität (18) magnetisch gekoppelt ist, so dass eine parasitäre Induktivität (12) im Parallelzweig, die als Ersatzelement für die magnetische Kopplung (20) der Induktivitäten (16, 18) dient, reduziert wird.
- Elektrisches verbinden der beiden Induktivitäten (16, 18) und der Kapazität (10) durch eine Lötverbindung (48) miteinander, wobei die Lötverbindung (48) als eine Temperaturschmelzsicherung dient, die im Falle eines Überstromes durch die Spule (42) den Strom unterbricht, und so die Spulen (42) vor Überhitzung schützt.

## Claims

1. Filter circuit for reducing electrical interference emissions in an on-board electrical system (2) of a motor vehicle, comprising:
- a first inductance (16) in a series branch; and
- a capacitance (10) in a parallel branch, wherein the first inductance (16) and the capacitance (10) are connected to one another via a node;
- a second inductance (18) in the series branch, said second inductance being connected to the first inductance (16) and the capacitance (10) via the node, wherein the first inductance (16) is magnetically coupled to the second inductance (18), thereby reducing a parasitic inductance (12) in the parallel branch,
- the first and second inductances (16, 18) are embodied as a single coil (42), such that the node is arranged on a winding of the single coil,
**characterized**
- **in that** the two inductances (16, 18) and the capacitance (10) are electrically connected to one another by a soldering connection (48), wherein the soldering connection (48) serves as a thermal fusible link which interrupts the current in the case of an overcurrent through the coil (42), and thus protects the coils (42) against overheating.

2. Filter circuit according to Claim 1, wherein the first and second inductances (16, 18) are embodied as windings.

3. Filter circuit according to either of the preceding claims, wherein the coupling (20) between the two inductances (16, 18) is chosen in such a way that a negative inductance (22) which represents the coupling (20) and which is connected in series with the capacitance (10) in the equivalent circuit diagram of the inductances (16, 18) compensates for the effect of the parasitic inductance and thus cancels the latter (12).

4. Arrangement comprising an electrical converter, comprising an on-board electrical system for transmitting electrical energy from or to the converter, and comprising a filter circuit according to any of the preceding claims.

5. Arrangement according to Claim 6, wherein the electrical converter is an electric motor.

6. Arrangement according to Claim 7, wherein the electric motor is a starter motor for starting an internal combustion engine.

7. Method for reducing electrical interference emissions in an on-board electrical system (2) of a motor vehicle, comprising the following steps:
- providing a filter circuit comprising a first inductance (16) in a series branch and a capacitance (10) in a parallel branch, wherein the first inductance (16) and the capacitance (10) are connected to one another via a node;
- providing a second inductance (18) in the series branch, said second inductance being connected to the first inductance (16) and the capacitance (10) via the node, wherein the first inductance (16) is magnetically coupled to the second inductance (18), thereby reducing a parasitic inductance (12) in the parallel branch that serves as a substitute element for the magnetic coupling (20) of the inductances (16, 18),
- electrically connecting the two inductances (16, 18) and the capacitance (10) to one another by a soldering connection (48), wherein the soldering connection (48) serves as a thermal fusible link which interrupts the current in the case of an overcurrent through the coil (42), and thus protects the coils (42) against overheating.

## Revendications

1. Circuit de filtrage destiné à réduire les émissions parasites électriques d'un réseau de bord (2) d'un véhicule à moteur, comprenant :
- une première inductance (16) dans une première branche série ; et
- une capacité (10) dans une branche parallèle, dans lequel l'inductance (16) et la capacité (10) sont connectées l'une à l'autre par l'intermédiaire d'un noeud ;
- une seconde inductance (18) dans une branche série, qui est connectée à la première inductance (16) et à la capacité (10) par l'intermédiaire du noeud, dans lequel la première inductance (16) est couplée magnétiquement à la seconde inductance (18) de manière à réduire une inductance parasite (12) dans la branche parallèle,
- les première et seconde inductances (16, 18) sont réalisées sous la forme d'une bobine unique (42) de manière à ce que le noeud soit disposé dans un enroulement de la bobine unique,
**caractérisé en ce que**
- les deux inductances (16, 18) et la capacité (10) sont connectées électriquement l'une à l'autre par une connexion par brasage (48), dans lequel la connexion par brasage (48) joue le rôle de fusible thermique qui interrompt le courant passant à travers la bobine (42) en cas de surintensité et par conséquent, protège les bobines (42) d'une surchauffe.

2. Circuit de filtrage selon la revendication 1, dans lequel les première et seconde inductances (16, 18) sont réalisées sous la forme d'enroulements.

3. Circuit de filtrage selon l'une quelconque des revendications précédentes, dans lequel le couplage (20) entre les deux inductances (16, 18) est sélectionné de manière à ce qu'une inductance négative (22) représentant le couplage (20), qui est connectée en série à la capacité (10) dans le schéma équivalent des inductances (16, 18), compense l'effet de l'inductance parasite et annule de ce fait (12) cette dernière.

4. Dispositif comportant un convertisseur électrique, comportant un réseau de bord destiné à transmettre de l'énergie électrique depuis ou vers le convertisseur et comportant un circuit de filtrage selon l'une quelconque des revendications précédentes.

5. Dispositif selon la revendication 6, dans lequel le convertisseur électrique est un moteur électrique.

6. Dispositif selon la revendication 7, dans lequel le moteur électrique est un démarreur destiné à démarrer un moteur à combustion interne.

7. Procédé destiné à réduire les émissions parasites électriques dans un réseau de bord (2) d'un véhicule à moteur, comportant les étapes consistant à :
- fournir un circuit de filtrage comportant une première inductance (16) dans une branche série et une capacité (10) dans une branche parallèle, dans lequel la première inductance (16) et la capacité (10) sont connectées l'une à l'autre par l'intermédiaire d'un noeud;
- prévoir dans la branche série une seconde inductance (18) qui est connectée à la première inductance (16) et à la capacité (10) par l'intermédiaire du noeud, dans lequel la première inductance (16) est couplée magnétiquement à la seconde inductance (18) de manière à réduire dans la branche parallèle une inductance parasite (12) qui joue le rôle d'élément de remplacement pour le couplage magnétique (20) des inductances (16, 18) ;
- connecter électriquement l'une à l'autre les deux inductances (16, 18) et la capacité (10) par une connexion par brasage (48), dans lequel la connexion par brasage (48) joue le rôle de fusible thermique qui interrompt le courant passant à travers la bobine (42) en cas de surintensité et par conséquent, protège les bobines (42) d'une surchauffe.
